# EUROPÄISCHE PATENTANMELDUNG

(11) **EP 3 244 711 A1**
(43) Veröffentlichungstag der Anmeldung: **15.11.2017**
(21) Anmeldenummer: 17166595.3
(22) Anmeldetag: 13.04.2017
(51) Int. Cl.: H05K 3/00, H01Q 1/52, H05K 3/34, H05K 9/00

(54) **ADAPTERPLATTE FÜR HF-STRUKTUREN**

(30) Priorität: 13.05.2016 DE 102016108868
(71) Anmelder: KATHREIN-Werke KG, 83022 Rosenheim (DE)
(72) Erfinder: Langenberg, Jörg, 83026 Rosenheim (DE); Leinenbach, Florian, 83059 Kolbermoor (DE); Ponn, Philipp, 83026 Rosenheim (DE)
(74) Vertreter: Nowack, Linda

(57) **Zusammenfassung**

Bereitgestellt wird eine Adapterplatte (1) für HF-Strukturen, die dazu eingerichtet ist, zwischen einer Rückseite einer Leiterplatte (2) und einem Reflektor (4) angeordnet zu werden, wobei die Adapterplatte elektrisch leitfähig ist, und die Adapterplatte an jeder Stelle, an der ein Element durch die Leiterplatte auf die Seite der Adapterplatte durchgeführt ist, eine Öffnung (102) oder eine Vertiefung (101) aufweist, wobei mindestens ein Element ausschließlich zur Massekontaktierung durch die Leiterplatte geführt ist.

## Beschreibung

Die Erfindung betrifft eine Adapterplatte für HF-Strukturen.

In Hochfrequenz (HF)-Anordnungen werden beispielsweise Schirmgehäuse oder Abschirmelemente zur Abschirmung störender Strahlung von bzw. auf elektrische Schaltkreise verwendet. Dabei wird als ausreichende Schirmung betrachtet, wenn in den Arbeits- bzw. Frequenzbereichen der zu schirmenden Leiterplatten bzw. des (Antennen-) Systems eine möglichst hohe Schirmdämpfung erreicht wird. Schirmgehäuse sind in der Elektrotechnik in unterschiedlichsten Ausführungen weit verbreitet und auch in der Antennen- und Filtertechnik sind verschiedene Ansätze zu finden.

Da bei der Montage Elemente durch die Leiterplatte durchragen, wird eine kapazitive Kopplung der Massefläche der Leiterplatte beeinträchtigt. Sollte die Baugruppe auf einem Reflektor bzw. Trägerelement befestigt werden, sind Öffnungen notwendig, die sowohl die Koppelfläche beeinträchtigen als auch die elektrischen Eigenschaften beeinflussen. Zusätzlich wird dadurch die mechanische Stabilität des Reflektors bzw. Trägerelements beeinträchtigt. Die Montage ist zudem aufwendig.

Aufgabe dieser Erfindung ist es, eine Adapterplatte bereitzustellen, die die Montage erleichtert, und dabei die elektrischen Eigenschaften nicht verfälscht.

Diese Aufgabe wird erfindungsgemäß durch die Merkmale des Patentanspruchs 1 gelöst. Vorteilhafte Ausgestaltungen sind Gegenstand der abhängigen Ansprüche.

Vorgeschlagen wird eine Adapterplatte für HF-Strukturen, die dazu eingerichtet ist, zwischen einer Rückseite einer Leiterplatte und einem Reflektor angeordnet zu werden, wobei die die Adapterplatte elektrisch leitfähig ist, und die Adapterplatte an jeder Stelle, an der ein Element durch die Leiterplatte auf die Seite der Adapterplatte durchgeführt ist, eine Öffnung oder eine Vertiefung aufweist, wobei mindestens ein Element ausschließlich zur Massekontaktierung durch die Leiterplatte geführt ist.

In einer Ausführung ist mindestens ein weiteres Element als Innenleiterpin ausgebildet.

In einer weiteren Ausführung ist die Dicke der Adapterplatte derart gewählt, dass sie einer Länge des längsten durch die Leiterplatte auf die Seite der Adapterplatte durchgeführten Elements entspricht. Durch die Bereitstellung der Adapterplatte kann ein vollflächiger Reflektor bzw. Trägerelement verwendet werden, d.h. es müssen keine Löcher oder Ausnehmungen im Reflektor bereitgestellt werden. Dies hat den Vorteil, dass störende Einflüsse durch die Pins, die durch die Leiterplatte hindurchstehen, auf den Reflektor vermieden werden. Somit stellt die Adapterplatte die benötigte Distanz zwischen Leiterplatte und Reflektor her, damit auf der Unterseite der Platine Richtung Reflektor durchstehende Elemente nicht kontaktieren und damit eine kapazitive Kopplung der Massefläche der Leiterplatte mit dem Reflektor erfolgen kann.

Vorgeschlagen wird ferner eine Adapterplatte für HF-Strukturen, die dazu eingerichtet ist, zwischen einer Rückseite einer Leiterplatte und einem Reflektor angeordnet zu werden, wobei die Adapterplatte an jeder Stelle, an der ein Element durch die Leiterplatte auf die Seite der Adapterplatte durchgeführt ist, eine Auswölbung aufweist, in welche das Element aufgenommen ist.

Durch die Bereitstellung einer Adapterplatte, welche an Stellen, an denen Elemente durch die Leiterplatte hindurchragen, eine Auswölbung aufweist, durch welche diese Elemente überdeckt werden, können ebenfalls störende Einflüsse durch die Elemente, die durch die Leiterplatte hindurchstehen, auf den Reflektor durch die Schirmwirkung der Adapterplatte vermieden werden.

Des Weiteren ist in einer Ausführung vorgesehen, dass die Adapterplatte derart ausgebildet ist, dass sie eine Ausnehmung zur Führung zumindest eines Kabels umfasst. Vorteilhaft ist es, wenn die Ausnehmung als Schirmelement zur Schirmung des strahlenden Teils des zumindest einen Kabels ausgebildet ist.

Durch die Bereitstellung der Adapterplatte können weitere Bauteile wie beispielsweise eine Kabelführung in die Adapterplatte integriert werden. Dies kann durch Prägen, Gießen oder Tiefziehen der Platte erfolgen, so dass kein eigenständiges Bauteil an die Platte angebracht werden muss. Vorteilhaft ist es, wenn die Führung gleichzeitig als Schirmelement für den strahlenden Teil des zu befestigenden Kabels gebildet ist. Somit kann z.B. die Schnittstelle der Anschlussleitung geschirmt werden, wodurch eine Vermeidung von Mantelwellen und unerwünschten Verkoppelungen realisierbar ist.

In einer vorteilhaften Ausgestaltung ist die Adapterplatte derart ausgebildet, dass sie ein Fixierungselement zur Fixierung zumindest eines Kabels umfasst.

Durch die Bereitstellung einer Kabelfixierung, egal ob mit oder ohne eine zusätzliche Kabelführung, wird die Montage des Kabels vereinfacht sowie eine Zug- und/oder Torsionsentlastung für das Kabel bereitgestellt. Der elektrische Kontakt des Außenleiters kann an die Adapterplatte integriert werden und somit kann eine Lötverbindung des Außenleiters auf der Leiterplatte vermieden werden.

In einer weiteren Ausführung ist vorgesehen, dass die Adapterplatte elektrisch leitende Umgebungselemente umfasst. Dies hat den Vorteil, dass auf der Leiterplatte mehr Platz für andere Elemente verbleibt.

In einer weiteren Ausführung ist die Adapterplatte aus Kunststoff mit leitender Beschichtung oder leitenden Eigenschaften gebildet.

In einer vorteilhaften Ausgestaltung umfasst die Adapterplatte zumindest eine an zumindest einem Teilbereich ihres äußeren Umfangs aus der Adapterplatte über zumindest einen Teilbereich des äußeren Rands der Leiterplatte gezogene Wand.

Die Bereitstellung einer oder mehrerer aus der Adapterplatte über den äußeren Rand der Leiterplatte gezogenen Wand bzw. Wände ist, dass eine Integration eines Teils des Strahlungsumfelds an die Adapterplatte möglich ist, d.h. dass keine zusätzlich anzubringenden Bauteile wie Trennwände zur Schirmung gegen benachbarte Bauteile nötig sind. Somit kann auch ein flexibler Aufbau von Antennen mit vorgefertigten Baugruppen erfolgen. Durch das Bereitstellen der Wand bzw. Wände über den Rand der Leiterplatte kann die Leiterplatte in die Adapterplatte aufgenommen werden und somit eine kompakte und geschirmte Baugruppe bereitgestellt werden, die als Gesamtpaket variabel mit anderen Baugruppen zusammengesetzt werden kann. Zusätzlich wird die Leiterplatte z.B. für den Transport geschützt und ausgesteift. Ferner ist vorgesehen, dass die zumindest eine Wand einstückig aus der Adapterplatte gebildet ist, wobei sie eine geschlossene Wanne bildet, in welcher die Leiterplatte mit darauf angeordneten HF-Bauelementen anordenbar ist.

Die Bereitstellung einer durch die Wand bzw. Wände gebildete Wanne erhöht die oben genannten Wirkungen zusätzlich. Durch eine Bildung der Wanne als einstückiges Element, z.B. durch Tiefziehen, wird eine einfache und kostengünstige Fertigung realisiert. Zusätzlich werden keine weiteren Bauteile benötigt, die an die Adapterplatte oder die Leiterplatte montiert werden müssen, um eine Schirmung und Versteifung der Leiterplatte zu erzielen.

In einer vorteilhaften Ausgestaltung ist vorgesehen, dass in der Adapterplatte mindestens ein weiteres elektrisches Funktionsbauteil einstückig aus der Adapterplatte ausgebildet ist. Vorteilhafterweise ist das mindestens eine elektrische Funktionsbauteil Bestandteil eines Strahlers einer Multibandantenne. Durch die Bereitstellung von einstückig aus der Platine gezogenen Funktionsbauteilen wird ebenfalls vermieden, dass zusätzlich zu montierende Bauteile benötigt werden. Außerdem wird der Herstellungsprozess vereinfacht, da mehrere Teile gleichzeitig bei der Herstellung der Adapterplatte hergestellt werden können.

Vorgesehen ist im Rahmen einer Ausführungsform der vorliegenden Erfindung des Weiteren, dass die Adapterplatte mittels eines Tiefziehverfahrens und/oder aus Kunststoff mit leitender Beschichtung oder leitenden Eigenschaften gebildet sein.

Durch das Tiefziehverfahren können auch komplexe Strukturen realisiert werden, z.B. rund, parabolisch, quadratisch oder asymmetrisch. Durch ein automatisiertes Design aufgrund von Simulationen kann eine Struktur für ein Strahlungsumfeld berechnet und dann einfach erzeugt werden, die eine optimale Schirmung für die gewünschte Anwendung aufweist. Je nach Verfahren können Kunststoffe verwendet werden, die mit einem Material mit leitenden Eigenschaften überzogen werden.

Des Weiteren ist vorgesehen, dass die durch die Leiterplatte auf die Seite der Adapterplatte durchgeführten Elemente Anschlüsse bzw. Pins, zumindest eine Verschraubung für HF-Bauteile auf der Leiterplatte und/oder Kabelanschlüsse umfassen.

Durch eine der erfindungsgemäßen Adapterplatten können jegliche durch die Leiterplatte hindurchragende Elemente abgeschirmt werden, entweder durch entsprechende Wahl der Dicke der Adapterplatte oder entsprechend ausgebildete Auswölbungen. Somit wird die Funktion des Reflektors nicht durch störende elektrische Kontakte, Felder oder sonstige Einflüsse beeinträchtigt.

In einer weiteren Ausführungsform ist vorgesehen, dass zumindest eine Adapterplatte mit zugehöriger Leiterplatte auf einem als Reflektor dienenden Schienensystem befestigt werden kann.

Vorteilhaft an der Verwendung eines Schienensystems ist, hier die einfach gehaltene Montage. Ein Reflektor ist zudem montierbar.

Ferner ist eine Antennenanordnung vorgesehen, umfassend mindestens eine vorher beschriebene Adapterplatte und einen Reflektor, wobei die mindestens eine Adapterplatte dazu eingerichtet ist, an dem Reflektor angeordnet zu werden, wobei der Reflektor mindestens eine Reflektorausnehmung aufweist, die mindestens einer korrespondierenden Vertiefung der Adapterplatte gegenüberliegt bzw. diese aufnimmt.

Somit kann der Reflektor direkt, d.h. mit möglichst geringem Abstand, mit der Adapterplatte gekoppelt werden. Obwohl Ausnehmungen in dem Reflektor bereitgestellt werden, wirken keine störenden Einflüsse von der Leiterplatte bzw. den durch diese durchragenden Elementen, da die Adapterplatte diese durch die Auswölbungen, welche die Elemente abdecken, abschirmt.

Weitere Merkmale und Vorteile der Erfindung ergeben sich aus der nachfolgenden Beschreibung von Ausführungsbeispielen der Erfindung, anhand der Figuren der Zeichnung, die erfindungsgemäße Einzelheiten zeigt, und aus den Ansprüchen. Die einzelnen Merkmale können je einzeln für sich oder zu mehreren in beliebiger Kombination bei einer Variante der Erfindung verwirklicht sein.

Bevorzugte Ausführungsformen der Erfindung werden nachfolgend anhand der beigefügten Zeichnung näher erläutert.
Fig. 1 zeigt eine Darstellung einer Adapterplatte gemäß einer Ausführung der vorliegenden Erfindung.
Fig. 2 zeigt eine Darstellung einer Adapterplatte gemäß einer weiteren Ausführung der vorliegenden Erfindung.
Fig. 3 zeigt eine Darstellung einer Kabelführung und Kabelfixierung an der Adapterplatte gemäß einer weiteren Ausführung der vorliegenden Erfindung.
Fig. 4 zeigt eine Darstellung einer aus der Adapterplatte und über den äußeren Rand der Leiterplatte gezogenen Wand gemäß einer Ausführung der vorliegenden Erfindung.
Fig. 5 zeigt eine Untersicht auf eine Adapterplatte mit mehreren daraus und über den äußeren Rand der Leiterplatte gezogenen Wände gemäß einer weiteren Ausführung der vorliegenden Erfindung.
Fig. 6 zeigt eine Untersicht auf eine einstückig als Wanne gebildete Adapterplatte gemäß einer weiteren Ausführung der vorliegenden Erfindung.
Fig. 7 zeigt eine Darstellung von aus der Adapterplatte und über den äußeren Rand der Leiterplatte gezogenen Struktur, die als integriertes elektrisches Funktionsbauteil dient, gemäß einer Ausführung der vorliegenden Erfindung.
Fig. 8 zeigt eine Darstellung von in Figur 7 gezeigten und nebeneinander angeordneten Strukturen, die zusammen ein Strahlungselement bilden, gemäß einer Ausführung der vorliegenden Erfindung.
Fig. 9 zeigt eine Darstellung von auf einem Schienensystem angeordneten Bauteilkomplexen gemäß einer Ausführung der vorliegenden Erfindung.

In den nachfolgenden Figurenbeschreibungen sind gleiche Elemente bzw. Funktionen mit gleichen Bezugszeichen versehen.

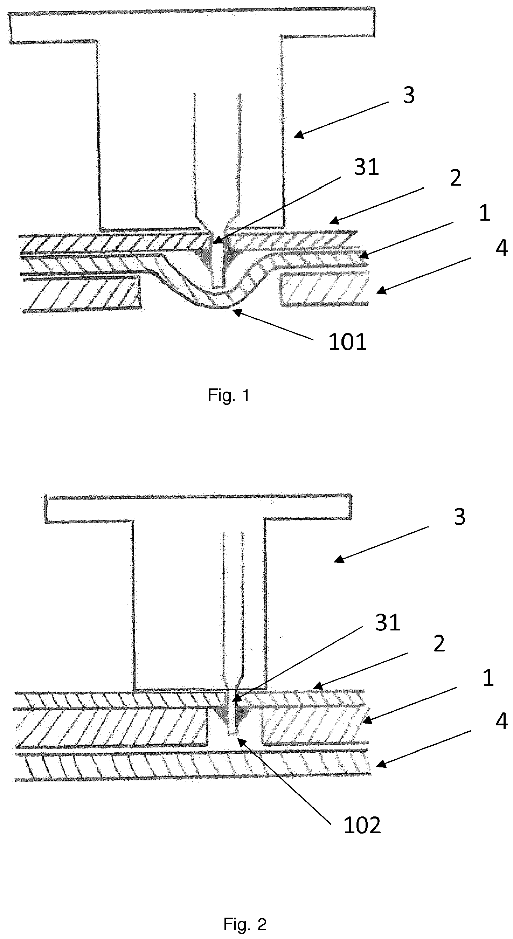

Figur 1 zeigt eine Ausführung einer erfindungsgemäßen Adapterplatte 1, die derart ausgelegt ist, dass durch die Rückseite der Leiterplatte 2 durchstehende Elemente 31, z.B. Pins, eines auf der Leiterplatte 2 angeordneten Bauteils 3, hier beispielhaft eines Dipols, dadurch abgeschirmt werden, dass die Adapterplatte an Stellen, an denen Elemente 31 durch die Leiterplatte hindurchstehen, eine Ausbuchtung 101 aufweist. Der unterhalb der Adapterplatte 1 angeordnete Reflektor 4 kann bzw. sollte an diesen Stellen eine Ausnehmung bzw. Lücke aufweisen, so dass die Ausbuchtung bzw. Vertiefung 101 der Adapterplatte 1 genügend Platz hat. Hier wird der Pin geschirmt.

Eine alternative gleichwertige erfindungsgemäße Adapterplatte 1 ist in Figur 2 gezeigt. Hier ist ebenfalls eine Adapterplatte 1 zwischen Leiterplatte 2 und Reflektor 4 bereitgestellt. Die Adapterplatte 1 ist in dieser Ausführung allerdings derart ausgebildet, dass sie an Stellen, an denen ein Element 31 durch die Leiterplatte 2 hindurchsteht, eine Lücke bzw. Öffnung 102 aufweist, in die das Element 31 aufgenommen wird. Vorteilhaft ist es, wenn die Adapterplatte 1 deshalb eine Dicke aufweist, die mindestens der Länge des am weitesten durch die Leiterplatte 2 durchstehenden Elements 31 entspricht. Durch die Dickenvorgabe kann die Adapterplatte 1 jedes Element 31 aufnehmen und der Reflektor 4 kann vollflächig über die gesamte Unterseite der Leiterplatte 2 und der Adapterplatte 1 gebildet werden, d.h. es müssen keine Löcher in das Reflektorblech gebohrt werden, so dass keine störenden Einflüsse auf den Reflektor wirken.

Die Adapterplatte 1 in beiden Ausführungen kann durch ausreichend dünne Folien und/oder Lack und/oder geeignete Beschichtungen elektrisch isoliert sein, so dass eine kapazitive Kopplung zwischen Massefläche der Leiterplatte 2 und dem Reflektor 4 ermöglicht werden kann.

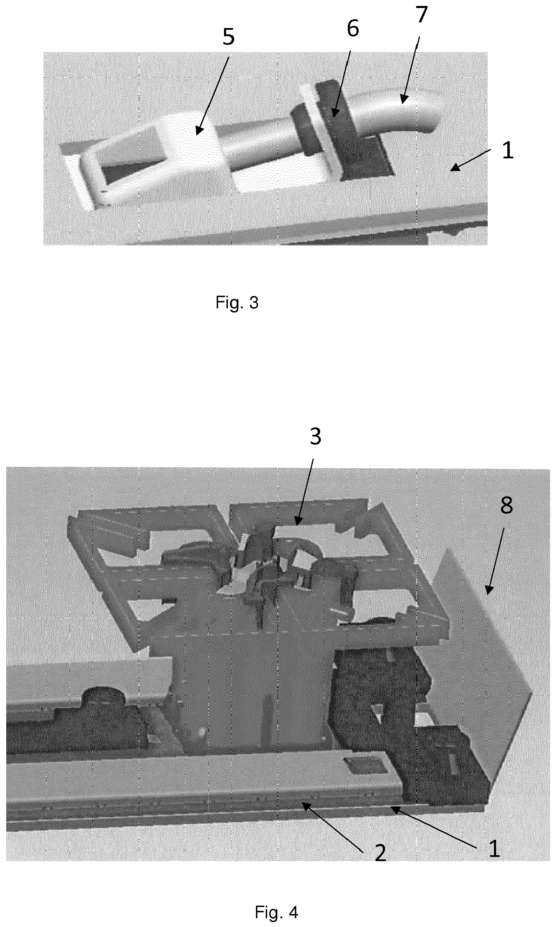

Figur 3 zeigt eine an der Adapterplatte 1 angeordnete und aus der Adapterplatte 1 gebildete Kabelführung 5 und Kabelfixierung 6. In der Kabelführung 5 kann beispielsweise eine Anschlussleitung 7, z.B. ein Koaxialkabel, befestigt werden. Vorteilhafterweise dient die Kabelführung 5 gleichzeitig als Abschirmelement, das den strahlenden Teil des Kabels 7 elektrisch schirmt. Vorteilhafterweise weist die Kabelführung 5 ein Loch bzw. eine Ausnehmung an der Stelle auf, an der das Kabel 7 an die Leiterplatte 2 angelötet bzw. mit der Leiterplatte 2 befestigt werden soll.

Die in Figur 3 gezeigte Kabelfixierung 6 ist sowohl für die Montage des Kabels 7 vorteilhaft als auch im Betrieb, da sie eine Zug- und/oder Torsionsentlastung für die Kontaktstelle des Kabels 7 bietet. Eine aus der Adapterplatte 1 gebildete Kabelfixierung 6 kann auch ohne eine Kabelführung 5 bereitgestellt werden und vice versa.

Die Kabelführung 5 und Kabelfixierung 6 können aus der Adapterplatte 1 durch Stanzen, Prägen oder beim Gießen geformt werden oder in eine Lücke der Adapterplatte 1 als eigenständiges Bauteil zwischen die Adapterplatte 1 und die Leiterplatte 2 integriert werden, wie in Figur 3 dargestellt.

Figur 4 zeigt eine an der Adapterplatte 1 angeordnete und aus der Adapterplatte 1 gebildete Wand 8, die über den äußeren Rand der Leiterplatte gezogen ist bzw. geklappt werden kann. Eine einzelne aus der Adapterplatte 1 gezogene Wand 8 kann als Trennwand zur Abschirmung einzelner Bauteile 3 bzw. Komponenten einer Antenne, z.B. Dipolen etc., voneinander oder von anderen benachbart angeordneten Bauteilen 3 bzw. Komponenten dienen. Die Strahlungseigenschaften werden dadurch beeinflusst, insbesondere die Umgebungsformung. Somit wird kein weiteres Bauteil benötigt und die Montage vereinfacht sich.

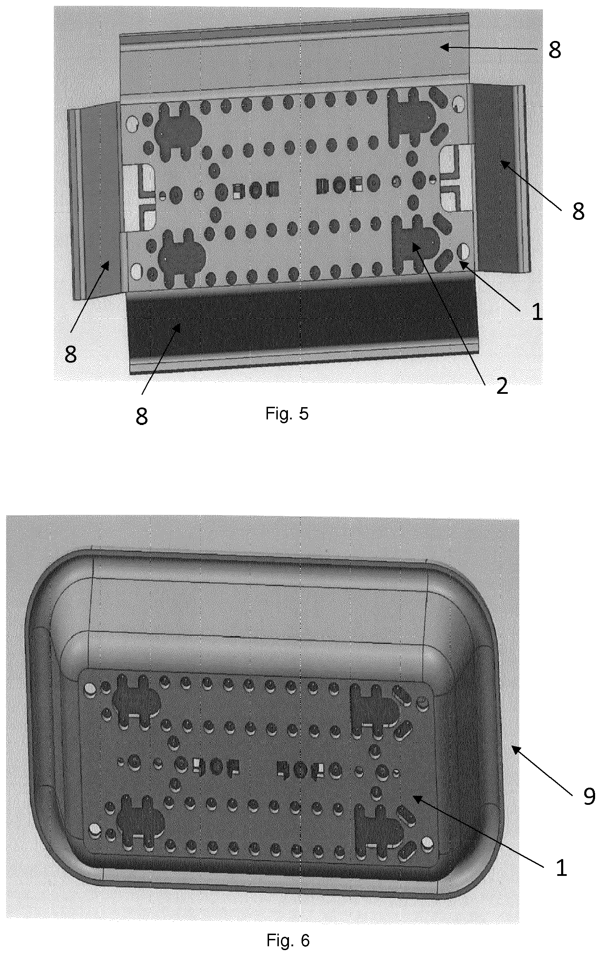

Figur 5 zeigt eine Untersicht auf eine Adapterplatte 1 mit vier daraus und über den äußeren Rand der Leiterplatte 2 gezogenen bzw. klappbaren Wänden 8. Die in Figur 5 gezeigten Wände 8 sind an den jeweiligen zwei Längsseiten und den zwei kurzen Seiten der Adapterplatte 1 angeordnet. Sie können beispielsweise hergestellt werden, indem sie aus einem die Adapterplatte 1 bildenden Blech ausgestanzt werden. Durch umknicken bzw. umklappen der Wände 8 über den äußeren Rand der Leiterplatte 2 bilden die Wände 8 dann eine Art Gehäuse um die Leiterplatte 2 und die darauf befindlichen Bauteile, so dass ein Strahlungsumfeld abgebildet werden kann und eine Schirmung vor äußeren Einflüssen erfolgen kann. Zusätzlich wird ein System bereitgestellt, das alle auf der Leiterplatte 2 angeordneten Komponenten, beispielsweise zwei auf der Leiterplatte 2 angeordnete Dipolstrahler etc., umfasst und somit als Komplettset in Umgebungen platziert werden kann, in denen eine herkömmliche Bauform schwierig zu platzieren wäre, da die Montage zu aufwändig oder ein flexibler Aufbau nötig wäre.

Figur 6 zeigt eine Untersicht auf eine einstückig als Wanne 9 gebildete Adapterplatte 1. Bei dieser Ausführung kann die Adapterplatte 1 inklusive der Wände 8 z.B. durch Gießen oder Tiefziehen aus einem Stück gebildet werden. Dadurch werden keine weiteren Elemente benötigt, welche einzelne Wände zusammenhalten müssen, d.h. es kann eine wesentlich kostengünstigere Fertigung und einfachere Montage realisiert werden. Durch die Möglichkeit, die Adapterplatte 1 mit den Wänden 8 tiefzuziehen, können beliebige Formen wie oben beschrieben realisiert werden, so dass Leiterplatten 2 und Bauteile 3 beliebiger Form und Größe von der Adapterplatte 1 umschlossen werden. Durch die Möglichkeit, die Form zur Abbildung des Strahlungsumfelds mittels computergestützter Simulation zu ermitteln, wird ferner die Planung der Form für die Adapterplatte 1 erleichtert.

Zusätzlich wird durch die die Leiterplatte 2 umgebende Form die Leiterplatte 2 stabilisiert, so dass eine geringere Bruchgefahr oder Gefahr der Beschädigung durch z.B. Transport der Leiterplatte resultiert.

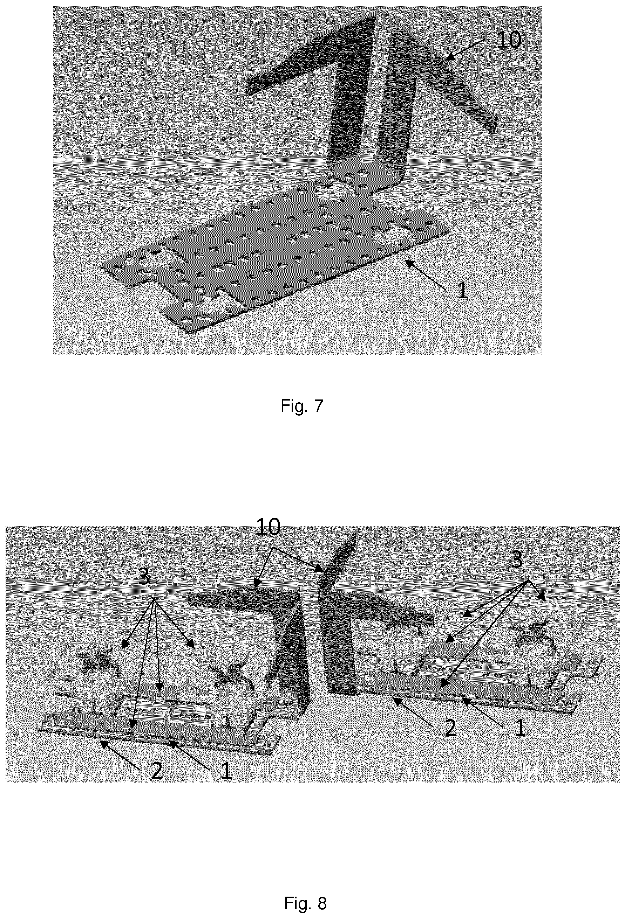

Figur 7 zeigt eine Darstellung einer aus der Adapterplatte und über den äußeren Rand der Leiterplatte gezogenen Struktur, die als integriertes elektrisches Funktionsbauteil dient. Hier sind zudem Öffnungen für die Innenleiter gezeigt, die die Wahrscheinlichkeit des Auftretens von Verkopplungseffekten minimieren.

Figur 8 zeigt eine Darstellung von in Figur 7 gezeigten und nebeneinander angeordneten Strukturen, die zusammen ein Strahlungselement 10 bilden. Gezeigt ist in Figur 7 das Prinzip der Integration zumindest eines Teils eines elektrischen Funktionsbauteils 10 in die Adapterplatte 1. Dieses elektrische Funktionsbauteil 10 kann mit der Adapterplatte 1 z.B. durch Gießen, Tiefziehen oder Stanzen gebildet werden und ist mit der Adapterplatte 1 einstückig gebildet. Dies vereinfacht die Herstellung und Montage. In Figur 8 ist die Funktionsweise beispielhaft gezeigt. Zwei Adapterplatten 1 mit darauf angeordneter Leiterplatte 2 und Bauteilen 3 werden derart aneinander angeordnet, dass die jeweilige elektrischen Funktionsbauteile 10 sich in einem Abstand gegenüber liegen und somit in Kombination ein Strahlungselement 10 erzeugen, z.B. ein Low-Band-Strahlungselement.

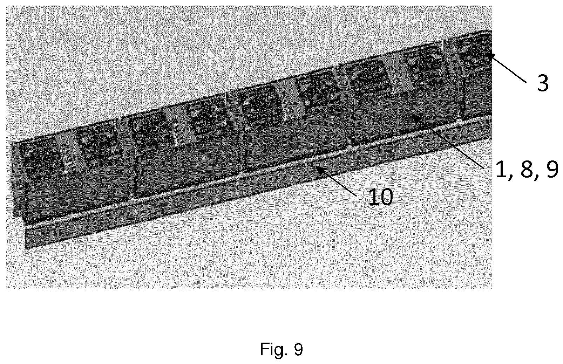

Figur 9 zeigt eine Darstellung von auf einem Schienensystem angeordneten Bauteilkomplexen, umfassend zumindest eine auf einer mit Bauteilen 3 bestückte Leiterplatte 2 angeordnete Adapterplatte 1, die hochgezogene Wände 8 oder eine Wanne 9 aufweist. Da ein Bauteilkomplex bzw. ein Komplettset durch die Ausführungen der vorliegenden Erfindung bereitgestellt werden kann, ist es möglich, die einzelnen Bauteilkomplexe auf einem Schienensystem 11 anzuordnen, so dass kein aufwändiger Reflektor mehr benötigt wird.

Die vorliegende Erfindung mit ihren Abwandlungen stellt eine Adapterplatte bereit, durch die keine Eigenschaften des Reflektors durch unerwünschte Effekte aufgrund von Elementen, die durch die Leiterplatte hindurchstehen, vermindert oder gestört werden. Zusätzlich wird die sensible Leiterplatte durch die Adapterplatte verstärkt und damit weniger anfällig für Beschädigungen durch z.B. Transport. Außerdem können Teile des Strahlungsumfelds an die Adapterplatte gekoppelt werden und eine Form entsprechend der Anwendung für die Adapterplatte gewählt werden, d.h. die Flexibilität sowohl für die Anordnung des Bauteilkomplexes innerhalb z.B. einer Antenne als auch die Herstellung werden deutlich vereinfacht und flexibler.

### Bezugszeichenliste

- 1: Adapterplatte
- 101: Ausbuchtung bzw. Auswölbung
- 102: Lücke bzw. Öffnung in Adapterplatte
- 2: Leiterplatte
- 3: Bauteil
- 31: Durch die Leiterplatte durchstehendes Element
- 4: Reflektor
- 5: Kabelführung
- 6: Kabelfixierung
- 7: Kabel
- 8: Wand
- 9: Wanne
- 10: Strahlungselement
- 11: Schienensystem

## Patentansprüche

1. Adapterplatte (1) für HF-Strukturen, die dazu eingerichtet ist, zwischen einer Rückseite einer Leiterplatte (2) und einem Reflektor (4) angeordnet zu werden, wobei
- die Adapterplatte (1) elektrisch leitfähig ist,
- die Adapterplatte (1) an jeder Stelle, an der ein Element durch die Leiterplatte (2) auf die Seite der Adapterplatte (1) durchgeführt ist, eine Öffnung (102) oder eine Vertiefung (101) aufweist, wobei mindestens ein Element ausschließlich zur Massekontaktierung durch die Leiterplatte geführt ist.

2. Adapterplatte (1) für HF-Strukturen nach Anspruch 1, wobei mindestens ein weiteres Element als ein Innenleiterpin ausgebildet ist.

3. Adapterplatte (1) für HF-Strukturen nach Anspruch 1 oder 2, wobei die Adapterplatte (1) derart ausgebildet ist, dass sie eine Ausnehmung (5) zur Führung zumindest eines Kabels (7) umfasst.

4. Adapterplatte (1) für HF-Strukturen nach Anspruch 3, wobei die Ausnehmung als Schirmelement (5) zur Schirmung des strahlenden Teils des zumindest einen Kabels (7) ausgebildet ist.

5. Adapterplatte (1) für HF-Strukturen nach einem der vorhergehenden Ansprüche, wobei die Adapterplatte (1) derart ausgebildet ist, dass sie ein Fixierungselement (6) zur Fixierung zumindest eines Kabels (7) umfasst.

6. Adapterplatte (1) für HF-Strukturen nach einem der vorhergehenden Ansprüche, wobei die Adapterplatte (1) elektrisch leitende Umgebungselemente umfasst.

7. Adapterplatte (1) für HF-Strukturen nach einem der vorhergehenden Ansprüche, wobei die Adapterplatte (1) aus Kunststoff mit leitender Beschichtung oder leitenden Eigenschaften gebildet ist.

8. Adapterplatte (1) für HF-Strukturen nach einem der vorhergehenden Ansprüche, wobei die Adapterplatte (1) zumindest eine an zumindest einem Teilbereich ihres äußeren Umfangs aus der Adapterplatte (1) über zumindest einen Teilbereich des äußeren Rands der Leiterplatte (2) gezogene Wand (8) umfasst.

9. Adapterplatte (1) für HF-Strukturen nach Anspruch 8, wobei die zumindest eine Wand (8) einstückig aus der Adapterplatte (1) gebildet ist, wobei sie eine geschlossene Wanne (9) bildet, in welcher die Leiterplatte (2) mit darauf angeordneten HF-Bauelementen anordenbar ist.

10. Adapterplatte (1) für HF-Strukturen nach einem der vorhergehenden Ansprüche, wobei mindestens ein weiteres elektrisches Funktionsbauteil (10) einstückig aus der Adapterplatte (1) ausgebildet ist.

11. Adapterplatte (1) für HF-Strukturen nach Anspruch 10, wobei das mindestens eine elektrische Funktionsbauteil (10) Bestandteil eines Strahlers einer Multibandantenne ist.

12. Adapterplatte (1) für HF-Strukturen nach einem der vorhergehenden Ansprüche, wobei die Adapterplatte (1) mittels eines Tiefziehverfahrens gebildet ist.

13. Adapterplatte (1) für HF-Strukturen nach einem der vorhergehenden Ansprüche, wobei die durch die Leiterplatte (2) auf die Seite der Adapterplatte (1) durchgeführten Elemente (31) Anschlüsse bzw. Pins, zumindest eine Befestigung für HF-Bauteile auf der Leiterplatte (2) und/oder Kabelanschlüsse umfassen.

14. Adapterplatte (1) für HF-Strukturen nach einem der vorhergehenden Ansprüche, wobei zumindest eine Adapterplatte (1) mit zugehöriger Leiterplatte (2) auf einem als Reflektor (4) dienenden Schienensystem (11) befestigt werden kann.

15. Antennenanordnung, umfassend mindestens eine Adapterplatte (1) nach einem der vorhergehenden Ansprüche und einen Reflektor (4), wobei die mindestens eine Adapterplatte dazu eingerichtet ist, an dem Reflektor (4) angeordnet zu werden, wobei der Reflektor (4) mindestens eine Reflektorausnehmung aufweist, die mindestens einer korrespondierenden Vertiefung (101) der Adapterplatte (1) gegenüberliegt bzw. diese aufnimmt.
